Europäisches Patentamt

European Patent Office

Office européen des brevets

(19)

(11) Veröffentlichungsnummer: **0 082 469**
**B1**

(12) **EUROPÄISCHE PATENTSCHRIFT**

(45) Veröffentlichungstag der Patentschrift:
**20.04.88**

(51) Int. Cl.⁴: **H 01 R 13/66**

(21) Anmeldenummer: **82111616.7**

(22) Anmeldetag: **14.12.82**

(54) Gehäuse zur Aufnahme der zur Beschaltung einer Magnetspule eines Hydraulikventils oder dgl. erforderlichen elektrischen Bauteile.

(30) Priorität: **19.12.81 DE 3150438**

(43) Veröffentlichungstag der Anmeldung:
**29.06.83 Patentblatt 83/26**

(45) Bekanntmachung des Hinweises auf die Patenterteilung:
**20.04.88 Patentblatt 88/16**

(84) Benannte Vertragsstaaten:
**AT BE CH FR GB IT LI LU NL SE**

(56) Entgegenhaltungen:
**DE - A - 2 055 183**
**DE - A - 2 933 818**
**DE - B - 1 113 516**
**DE - U - 7 829 256**
**GB - A - 820 687**

(73) Patentinhaber: **Murr-Elektronik GmbH, Fabrikstrasse 8, D-7155 Oppenweiler (DE)**

(72) Erfinder: **Laible, Helmut, Fritz-Ehrmann-Strasse 29, D-7157 Murrhardt (DE)**
Erfinder: **Hafner, Franz, Elbinger Strasse 7, D-7155 Oppenweiler (DE)**

(74) Vertreter: **Vogel, Georg, Hermann-Essig-Strasse 35 Postfach 105, D-7141 Schwieberdingen (DE)**

## Beschreibung

Die Erfindung betrifft ein Gehäuse zur Aufnahme der zur Beschaltung einer Magnetspule eines Hydraulikventils oder dgl. erforderlichen elektrischen Bauteile, wobei die Magnetspule mit einem Steckanschluss mit Steckkontakten versehen ist und das Gehäuse eine Anschlussplatte mit Steckaufnahmen für diese Steckkontakte aufweist, wobei diese Anschlussplatte mit elektrischen Leitern versehen ist, welche die Steckkontakte mit den elektrischen Bauelementen im Gehäuse verbinden, und wobei diese Anschlussplatte zwischen dem Steckanschluss und dem auf diesen aufsteckbaren Stecker angeordnet ist.

Ein derartiges Gehäuse zeigt das DE-U-78 29 256. Die Anschlussplatte wird dabei gleichzeitig als Dichtung zwischen dem Steckanschluss des Hydraulikventils und dem Stecker ausgenützt. Das eigentliche Gehäuse ist seitlich an die Anschlussplatte angeformt und liegt daher ausserhalb des Steckers.

Diese Zwischenschaltung des Gehäuses zwischen dem Steckanschluss des Hydraulikventils und dem Stecker hat den Nachteil, dass der Stecker vom Steckanschluss abgezogen werden kann, ohne dass das zugehörige Gehäuse mit den elektrischen Bauelementen abgezogen wird. Das Gehäuse ist eine getrennte Baueinheit, die beliebig mit Steckern kombiniert werden kann. Diese Trennung führt gelegentlich dazu, dass die richtige Zuordnung von Stecker und Gehäuse nicht gegeben ist. Dies ist besonders dann von Nachteil, wenn eine Maschine oder dgl. mehrere Hydraulikventile aufweist. Dann kommt es besonders gerne zu derartig falschen Zuordnungen. Ein weiterer Nachteil dieser Anordnung ist, dass das Gehäuse neben dem Stecker einen beachtlichen Platz beansprucht, welcher in manchen Einbaufällen gar nicht zur Verfügung steht.

Es ist Aufgabe der Erfindung, ein Gehäuse der eingangs erwähnten Art zu schaffen, bei dem auf einfache Weise der Stecker mit dem Gehäuse zu einer Einheit zusammengefasst wird, die nur als Ganzes vom Steckanschluss des Hydraulikventils abgezogen werden kann. Darüber hinaus soll diese Einheit so gestaltet sein, dass sie vom Platzbedarf günstiger ist.

Diese Aufgabe wird nach der Erfindung dadurch gelöst, dass das Gehäuse aus einem wannenartigen Unterteil und einem wannenartigen Oberteil zusammengesetzt ist, dass das Unterteil und das Oberteil im Bereich ihrer Verbindungsebene mittels aufeinander abgestimmter Rastelemente miteinander verbindbar sind, dass der Boden des Unterteils als Anschlussplatte ausgebildet ist und die elektrischen Leiter aufweist, welche in einer Seitenwand des Unterteils bis zum Oberteil geführt sind und dass der Boden und die Seitenwände des Unterteils und der Boden des Oberteils den Stecker an fünf Seiten zumindest teilweise umschliessen und so im Gehäuse festhalten bzw. festlegen.

Das Gehäuse und der Stecker bilden eine Einheit, welche nach der Montage mit dem Steckanschluss verbunden und von diesem leicht wieder gelöst werden kann. Da das Gehäuse über dem Stecker angeordnet ist, wird kein Raum um den Steckanschluss herum belegt. Vielmehr genügt es, wenn der Raum über dem Steckanschluss frei ist, was ja für das Aufstecken des Steckers der Fall sein muss.

Eine Ausgestaltung ist dadurch gekennzeichnet, dass das Unterteil mit rechteckförmigem Querschnitt ausgebildet ist, dass eine Schmalseite des Unterteils offen ist und dass auf der gegenüberliegenden Schmalseite in die Seitenwand die elektrischen Leiter eingebettet sind und über die offene Oberseite des Unterteils vorstehen. Die offene Schmalseite lässt die Einführung des Steckers in das Unterteil zu und das Anschlusskabel des Steckers wird an dieser Seite aus dem Unterteil herausgeführt.

Die Weiterführung der elektrischen Leiter der Anschlussplatte in das Oberteil ist nach einer Ausgestaltung dadurch gelöst, dass die über die Oberseite des Unterteils vorstehenden elektrischen Leiter in eine mit dem Unterteil verbundene Platte eingebettet sind, welche in eine Aufnahme des Oberteils einschiebbar ist und dass die Enden der elektrischen Leiter an der Oberkante der Platte herausgeführt und in den Innenraum des Oberteils geführt sind. Die Auslegung ist dabei vorzugsweise so, dass die Aufnahme für die Platte des Unterteils durch eine Zwischenwand zu der Seitenwand einer Schmalseite des Oberteils gebildet ist und dass der Boden des Oberteils zwischen dieser Zwischenwand und dieser Seitenwand durchbrochen ist.

Die Verbindung zwischen Unterteil und Oberteil erfolgt nach einer anderen Ausgestaltung dadurch, dass die den Längsseiten zugeordneten Seitenwände des Unterteils an der Oberseite und die den Längsseiten zugeordneten Seitenwände des Oberteils an der Unterseite plattenförmige Rastfahnen und darauf abgestimmte Rastaufnahmen in aufeinander abgestimmter Anordnung und Verteilung tragen. Damit diese Rastverbindungen sicher hergestellt werden und das Unterteil und das Oberteil in einer definierten Stellung verbunden werden, sieht eine Weiterbildung vor, dass im Bereich der Rastfahnen und Rastaufnahmen auf der Innenseite Führungsplatten an dem Unterteil und Oberteil angeformt sind, welche die Rastfahnen und Rastaufnahmen von Unterteil und Oberteil auf die beiden Verbindungsebenen im Bereich der den Längsseiten zugeordneten Seitenwände ausrichten.

Damit der Stecker in drei verschiedenen, jeweils um 90° verdrehten Stellungen in das Gehäuse eingesetzt werden kann, ist nach einer weiteren Ausgestaltung vorgesehen, dass die Seitenwände auf den Längsseiten des Unterteils mit halbkreisförmig auslaufenden Ausnehmungen versehen sind, welche zur offenen Schmalseite des Unterteils hin offen und an die Abmessungen des aus dem Gehäuse ragenden Teils des Steckers angepasst sind.

Das aus Unterteil und Oberteil zusammengesetzte Gehäuse wird dadurch vervollständigt,

dass die offene Oberseite des Oberteils mittels eines Deckels verschliessbar ist, der auf seiner Oberseite mit einem Bezeichnungssteg versehen ist und Durchbrüche für Anzeigeelemente, wie Leuchtdioden oder dgl., aufweist. Die Verbindung zwischen dem Deckel und dem Oberteil ist dabei so gelöst, dass das Oberteil auf seiner Innenseite Rastelemente trägt, welche in Rastaufnahmen eines Einsteckrandes des Deckels einrasten.

Die an sich bekannte Schraubverbindung zwischen dem Stecker und dem Steckanschluss lässt sich bei dieser Ausgestaltung des Gehäuses dadurch beibehalten, dass der Boden des Unterteils eine Bohrung für eine durch den Stecker geführte und in eine Gewindeaufnahme des Steckanschlusses einschraubbare Befestigungsschraube aufweist, und dass die Befestigungsschraube durch eine Bohrung im Deckel und eine am Oberteil angeformte Hülse einführbar ist, wobei die Bohrung im Deckel, die Durchgangsbohrung der Hülse und die Bohrung im Boden des Unterteils bei zusammengesetztem Gehäuse fluchten.

Die Festlegung der elektrischen Bauteile in dem Oberteil wird nach einer Ausgestaltung dadurch erreicht, dass nach dem Verbinden von Unterteil und Oberteil sowie dem Einbringen und Verbinden der elektrischen Bauteile mit den elektrischen Leitern das Oberteil mit Gussmasse vergossen wird.

Die Erfindung wird anhand von verschiedenen, in den Zeichnungen dargestellten Ausführungsbeispielen näher erläutert. Es zeigt:

Fig. 1 den Steckanschluss eines Hydraulikventils,

Fig. 2 ein Ausführungsbeispiel eines Unterteils des Gehäuses,

Fig. 3 ein Ausführungsbeispiel eines Oberteils des Gehäuses,

Fig. 4 einen Deckel als Abschluss des Oberteils nach Fig. 3,

Fig. 5 einen anderen Steckanschluss eines Hydraulikventils,

Fig. 6 eine Einheit aus Stecker und Gehäuse, welches aus Unterteil und Oberteil zusammengesetzt ist,

Fig. 7 einen Schnitt durch die Einheit nach Fig. 6, welcher parallel zu den Schmalseiten des Gehäuses verläuft, und

Fig. 8 einen um 90° versetzten Schnitt durch die Einheit nach Fig. 7, welcher parallel zu den Längsseiten des Gehäuses verläuft.

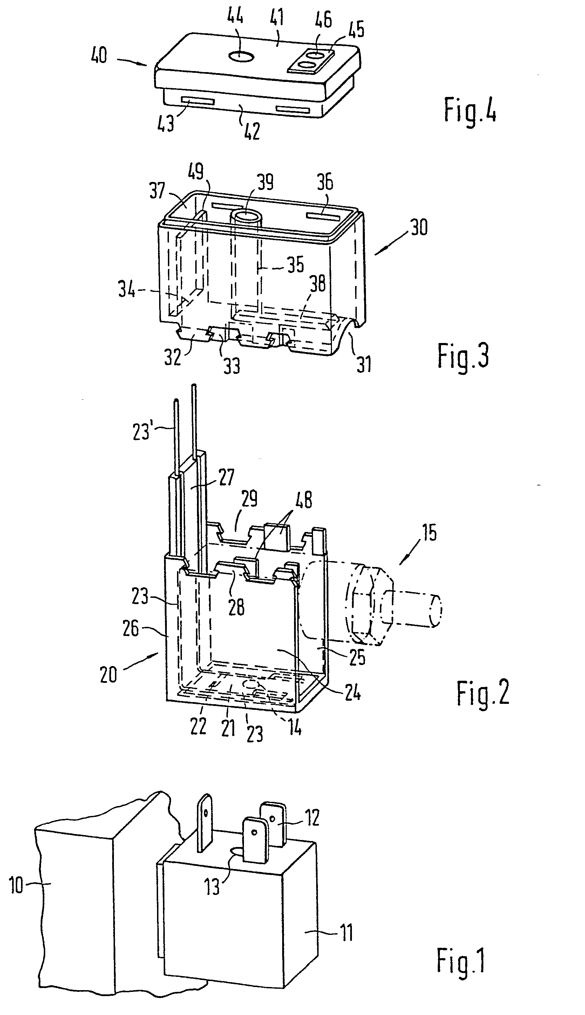

Wie Fig. 1 zeigt, ist am Hydraulikventil 10 ein Steckanschluss 11 angebracht, der drei Steckkontakte 12 in genormter Anordnung aufweist. Zwischen den Steckkontakten 12 ist eine Gewindeaufnahme 13 eingebracht.

Der Stecker 15 wird, wie Fig. 2 zeigt, in ein wannenartiges Unterteil 20 eingebracht, wobei eine Schmalseite des Unterteils 20 offen ist. Der Boden 21 des Unterteils 20 ist als Anschlussplatte ausgebildet, bei der die Steckaufnahmen 22 auf die Anordnung der Steckkontakte 12 am Steckanschluss 11 abgestimmt sind. In den Boden 21 und die Seitenwand 26 des Unterteils 20 sind elektrische Leiter 23 eingebettet, die im Bereich der Steckaufnahmen 22 freiliegen und an den Steckkontakten 12 anliegen, wenn die Anschlussplatte auf den Steckanschluss 11 gesteckt wird. Der Boden 21 des Unterteils hat noch eine Bohrung 14 für eine Befestigungsschraube, wie noch gezeigt wird.

Die elektrischen Leiter 23 ragen über die offene Oberseite des Unterteils 20 hinaus und sind in diesem Bereich bis auf die Anschlussenden 23' in die Platte 27 eingebettet.

Die Seitenwände 24 und 25 der Längsseite umschliessen den Stecker 15 an weiteren zwei Stellen. Die Oberkanten der Seitenwände 24 und 25 laufen in plattenförmige Rastfahnen 28 aus, die durch Rastaufnahmen 29 voneinander getrennt sind. Auf den Innenseiten der Seitenwände 24 und 25 sind Führungsplatten 48 angeformt, die die Rastfahnen 28 und die Rastaufnahmen 29 teilweise überdecken. Damit wird erreicht, dass beim Aufstecken des Oberteils 30 nach Fig. 3 die Rastfahnen 32 und die Rastaufnahmen 33 an den Unterkanten der Seitenwände des Oberteils 30 in eindeutiger Stellung geführt sind. Das Unterteil 20 und das Oberteil 30 sind im zusammengesetzten Zustand daher auf den Aussenflächen bündig. Auch das Oberteil 30 trägt entsprechende Führungsplatten im Bereich der Rastfahnen 32 und Rastaufnahmen 33, die aber gegenüber den Führungsplatten 48 des Unterteils 20 versetzt sind.

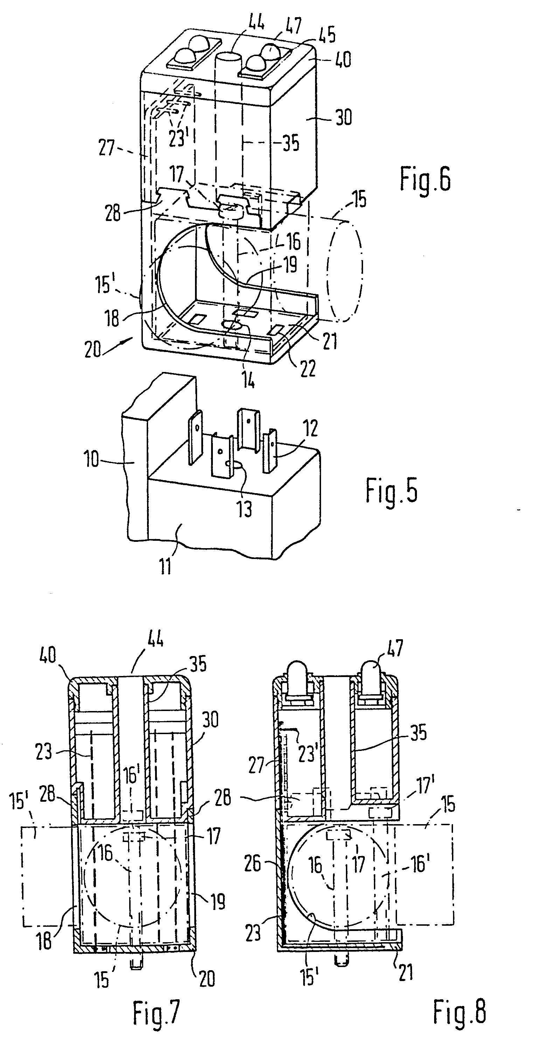

Das Oberteil 30 hat parallel zu der Seitenwand 37 eine Zwischenwand 49, die mit einem Durchbruch im Boden 31 eine Aufnahme 34 bildet, in die die Platte 27 mit den elektrischen Leitern 23 des Unterteils 20 eingeschoben werden kann. Ausserdem ist am Boden 31 des Oberteils 30 eine Hülse 35 mit der Durchgangsbohrung 39 angeformt. Die offene Oberseite des Oberteils 30 kann mittels des Deckels 40 nach Fig. 4 verschlossen werden. Dabei trägt der Einsteckrand 42 des Deckels 40 Rastaufnahmen 43, in die die Raststege 36 auf den Innenseiten der Seitenwände des Oberteils 30 einrasten. Die Anschlussenden 23' der elektrischen Leiter 23 werden in den Innenraum des Oberteils eingebogen und mit den elektrischen Bauelementen verbunden, die das Oberteil 30 aufnimmt. Nach der Verdrahtung kann das Oberteil 30 mit einer Gussmasse vergossen werden.

Der Deckel 40 trägt in der Deckplatte 41 mittig eine Bohrung 44 und seitlich davon einen Bezeichnungssteg 45 mit Durchbrüchen 46 für Anzeigeelemente.

Das Oberteil 30 wird mit dem Unterteil 20 verrastet und die elektrischen Bauelemente sind über die elektrischen Leiter 23 mit den Steckkontakten 12 des Steckanschlusses 11 verbunden. Der Stecker 15 kann über die offene Schmalseite des Unterteils 20 eingeführt werden, wobei Teile 38 des Bodens 31 des Oberteils 30 den Stecker 15 teilweise hintergreifen und festhalten. Mittels einer Befestigungsschraube, die durch die Bohrung 44 in der Deckplatte 41 des Deckels 40 und die Durchgangsbohrung 39 der Hülse 35 des Oberteils 30 eingeführt wird, kann der Stecker 15 mit dem Steckanschluss 11 verschraubt werden. Die durch den Stecker 15 geführte Befestigungsschraube wird dabei durch die Bohrung 14 im Boden 21 des Unterteils 20 herausgeführt und in die Gewindeaufnahme 13 des Steckanschlusses 11 eingeschraubt. Der Stecker 15 bildet nach der Montage mit dem zusammengesetzten Gehäuse eine Einheit, die auf den Steckanschluss 11 aufgesteckt und wieder von dem Steckanschluss 11 gelöst werden kann, ohne dass das Gehäuse von dem Stecker 15 getrennt wird. Nach dem Lösen der Befestigungsschraube kann der Stecker 15 jedoch wieder aus dem Gehäuse entnommen werden, er hält aber so fest, dass er nicht von selbst aus dem Gehäuse fällt.

Der Steckanschluss 11 des Hydraulikventils 10 nach Fig. 5 hat vier anders gestaltete Steckkontakte 12. Die Steckaufnahmen 22 im Boden 21 des Unterteils 20 sind wieder auf die Verteilung der Steckkontakte 12 abgestimmt. Die Anzahl der elektrischen Leiter 23 kann dabei auch grösser sein. Die Seitenwände 24 und 25 des Unterteils 20 haben halbkreisförmig auslaufende Ausnehmungen 18 und 19, welche zur offenen Schmalseite des Unterteils 20 hin offen sind. Der zylindrische Teil des Steckers 15, der aus dem Gehäuse ragt, bestimmt die Abmessungen dieser Ausnehmungen 18 und 19. Der Stecker 15 kann daher auch um 90° verdreht, in das Unterteil 20 eingesetzt werden, wie das Bezugszeichen 15' in Fig. 6 zeigt. Die Steckkontakte 12 des Steckanschlusses 11 sind ja symmetrisch angeordnet. Das Oberteil 30 ist mit dem Unterteil 20 verrastet und die Anschlussenden 23' der elektrischen Leiter 23 sind mit den im Oberteil 30 untergebrachten elektrischen Bauteilen verbunden. Die Befestigungsschraube 16 ist durch die Bohrung 44 im Deckel 40 und die Hülse 35 des Oberteils 30 eingeführt und liegt mit dem Schraubenkopf 17 in der abgesetzten Bohrung des Steckers 15. Ein Teil der Befestigungsschraube 16 ragt aus der Bohrung 14 im Boden 21 des Unterteils 20, so dass die Befestigungsschraube 16 in die Gewindeaufnahme 13 des Steckanschlusses 11 eingeschraubt werden kann, wie die Schnitte nach Fig. 7 und 8 erkennen lassen. Dabei ist im Boden 31 des Oberteils 30 eine Aufnahme, in der der Schraubenkopf 17' Platz findet, wenn der Stecker 15' in um 90° verdrehter Stellung eingesetzt wird und die Befestigungsschraube 16' nicht durch die Bohrung 14 im Boden 21 des Unterteils 20 herausgeführt werden kann. Der Schraubenkopf 17' ragt dann in die Aufnahme im Boden 31 des Oberteils 30. Die als Anzeigeelemente verwendeten Leuchtdioden 47 ragen aus den Durchbrüchen 46 der Bezeichnungsstege 45. Wie die Schnitte nach Fig. 7 und 8 zeigen, sind die Bohrung 44 im Deckel 40 und die Durchgangsbohrung 39 der Hülse 35 gross genug, damit auch der Schraubenkopf 17 der Befestigungsschraube 16 bis zum Stecker 15 eingeführt werden kann.

**Patentansprüche**

1. Gehäuse zur Aufnahme der zur Beschaltung einer Magnetspule eines Hydraulikventils (10) oder dgl. erforderlichen elektrischen Bauteile, wobei die Magnetspule mit einem Steckanschluss (11) mit Steckkontakten (12) versehen ist und das Gehäuse eine Anschlussplatte mit Steckaufnahmen (22) für diese Steckkontakte (12) aufweist, wobei diese Anschlussplatte mit elektrischen Leitern (23) versehen ist, welche die Steckkontakte (12) mit den elektrischen Bauelementen im Gehäuse verbinden, und wobei diese Anschlussplatte zwischen dem Steckanschluss (11) und dem auf diesen aufsteckbaren Stecker (15) angeordnet ist, dadurch gekennzeichnet, dass es aus einem wannenartigen Unterteil (20) und einem wannenartigen Oberteil (30) zusammengesetzt ist, dass das Unterteil (20) und das Oberteil (30) im Bereich ihrer Verbindungsebene mittels aufeinander abgestimmter Rastelemente (28, 29, 32, 33) miteinander verbindbar sind, dass der Boden (21) des Unterteils (20) als Anschlussplatte ausgebildet ist und die elektrischen Leiter (23) aufweist, welche in einer Seitenwand (26) des Unterteils (20) bis zum Oberteil (30) geführt sind und dass der Boden (21) und die Seitenwände (24, 25, 26) des Unterteils (20) und der Boden (31) des Oberteils (30) den Stecker (15, 15') an fünf Seiten zumindest teilweise umschliessen und so im Gehäuse festhalten bzw. festlegen.

2. Gehäuse nach Anspruch 1, dadurch gekennzeichnet, dass das Unterteil (20) mit rechteckförmigem Querschnitt ausgebildet ist, dass eine Schmalseite des Unterteils (20) offen ist und dass auf der gegenüberliegenden Schmalseite in die Seitenwand (26) die elektrischen Leiter (23) eingebettet sind und über die offene Oberseite des Unterteils (20) vorstehen.

3. Gehäuse nach Anspruch 2, dadurch gekennzeichnet, dass die über die Oberseite des Unterteils (20) vorstehenden elektrischen Leiter (23) in eine mit dem Unterteil (20) verbundene Platte (27) eingebettet sind, welche in eine Aufnahme (34) des Oberteils (30) einschiebbar ist, und dass die Enden der elektrischen Leiter (23) an der Oberkante der Platte (27) herausgeführt und in den Innenraum des Oberteils (30) geführt sind.

4. Gehäuse nach Anspruch 1, dadurch gekennzeichnet, dass die Seitenwände (24, 25) auf den Längsseiten des Unterteils (20) mit halbkreisförmig auslaufenden Ausnehmungen (18, 19) versehen sind, welche zur offenen Schmalseite des Unterteils (20) hin offen und an die Abmessungen des aus dem Gehäuse ragenden Teils des Steckers (15, 15') angepasst sind.

5. Gehäuse nach einem der Ansprüche 1 bis 4, dadurch gekennzeichnet, dass die den Längsseiten zugeordneten Seitenwände (24, 25) des Unterteils (20) an der Oberseite und die den Längsseiten zugeordneten Seitenwände des Oberteils (30) an der Unterseite plattenförmige Rastfahnen (28, 32) und darauf abgestimmte Rastaufnahmen (29, 33) in aufeinander abgestimmter Anordnung und Verteilung tragen.

6. Gehäuse nach Anspruch 5, dadurch gekennzeichnet, dass im Bereich der Rastfahnen (28, 32) und Rastaufnahmen (29, 33) auf der Innenseite Führungsplatten (48) an dem Unterteil (20) und Oberteil (30) angeformt sind, welche die Rastfahnen (28, 32) und Rastaufnahmen (29, 33) von Unterteil (20) und Oberteil (30) auf die beiden Verbindungsebenen im Bereich der den Längsseiten zugeordneten Seitenwände (24, 25) ausrichten.

7. Gehäuse nach einem der Ansprüche 1 bis 6, dadurch gekennzeichnet, dass die offene Oberseite des Oberteils (30) mittels eines Deckels (40) verschliessbar ist, der auf seiner Oberseite mit einem Bezeichnungssteg (45) versehen ist und Durchbrüche (46) für Anzeigeelemente, wie Leuchtdioden (47) oder dgl. aufweist.

8. Gehäuse nach Anspruch 7, dadurch gekennzeichnet, dass das Oberteil (30) auf seiner Innenseite Rastelemente (36) trägt, welche in Rastaufnahmen (43) eines Einsteckrandes (42) des Deckels (40) einrasten.

9. Gehäuse nach einem der Ansprüche 1 bis 8, dadurch gekennzeichnet, dass der Boden (21) des Unterteils (20) eine Bohrung (14) für eine durch den Stecker (15) geführte und in eine Gewindeaufnahme (13) des Steckanschlusses (11) einschraubbare Befestigungsschraube (16) aufweist, und dass die Befestigungsschraube (16) durch eine Bohrung (44) im Deckel (40) und eine am Oberteil (30) angeformte Hülse (35) einführbar ist, wobei die Bohrung (44) im Deckel (40), die Durchgangsbohrung (39) der Hülse (35) und die Bohrung (14) im Boden (21) des Unterteils (20) bei zusammengesetztem Gehäuse fluchten.

10. Gehäuse nach Anspruch 3, dadurch gekennzeichnet, dass die Aufnahme (34) für die Platte (27) des Unterteils (20) durch eine Zwischenwand zu der Seitenwand (37) einer Schmalseite des Oberteils (30) gebildet ist und dass der Boden (31) des Oberteils (30) zwischen dieser Zwischenwand (49) und dieser Seitenwand durchbrochen ist.

11. Gehäuse nach einem der Ansprüche 1 bis 10, dadurch gekennzeichnet, dass nach dem Verbinden von Unterteil (20) und Oberteil (30) sowie dem Einbringen und Verbinden der elektrischen Bauteile mit den elektrischen Leitern (23) des Oberteil (30) mit Gussmasse vergossen ist.

**Claims**

1. Housing for the installation of electric circuit elements required for a solenoid of a hydraulic valve (10) or similar, whereby the solenoid is provided with a plug-in conncetor (11) with pin contacts (12) and the housing is equipped with a connection plate with female connectors (22) for the above mentioned pin contacts (12), the connection plate having electrical leads (23) linking the pin contacts (12) with the electric circuit elements within the housing and the connection plate being located between the plug-in connector (11) and the plug (15) pluggable on it, characterized by the fact, that it comprises a trough-type lower part (20) and a trough-type upper part (30), that the lower part (20) and the upper part (30) can be coupled together in their connection plane area via latching elements (28, 29, 32, 33) matched to one another, that the bottom (21) of the lower part (20) is intended to be a connection plate and provided with the electrical leads (23) which are layed in the side wall (26) of the lower part (20) up to the upper part (30) and that the bottom (21) and the side walls (24, 25, 26) of the lower part (20), as well as the bottom (31) of the upper part (30) encloses partially at a minimum the plug (15, 15') on the five sides retaining it in this way within the housing.

2. Housing according to claim 1, characterized by the fact, that the lower part (20) has a rectangular cross section, that a narrow side of the lower part (20) is open and that on the opposite narrow side the electric leads (23) are embedded in the side wall (26) protruding from the open side of the lower part (20).

3. Housing according to claim 2, characterized by the fact, that the electrical leads (23) protruding from the upper side of the lower part (20) are embedded in a plate (27) linked with the lower part (20), the plate being withdrawable in an attachment (34) of the upper part (30), and that the ends of the electrical leads (23) are brougthout on the upper edge of the plate (27) and introduced in the interior of the upper part (30).

4. Housing according to claim 1, characterized by the fact, that the side walls (24, 25) have semicircular recesses (18, 19) on the longitudinal sides of the lower part (20), which are open to the open narrow side of the lower part (20) and matched to the dimensions of the plug (15, 15') protruding from the housing.

5. Housing according to one of the claims 1 to 4, characterized by the fact, that the side walls (24, 25) corresponding to the longitudinal sides of the lower part (20) have plate-type latching lugs (28, 32) on the upper side as well as the side walls of the upper part (30) corresponding to the longitudinal sides have them on the lower side, and are provided with latching attachments (29, 33) in an arrangement and a distribution matched to one another.

6. Housing according to claim 5, characterized by the fact, that in the latching lug (28, 32) and latching attachment (29, 33) areas guiding plates (48) are arranged on the inner side of the lower (20) and upper part (30), which align the latching lugs (28, 32) and attachments (29, 33) of the lower (20) and upper (30) parts relative to the connection planes in the side wall (24, 25) area corresponding to the longitudinal sides.

7. Housing according to one of the claims 1 to 6, characterized by the fact, that the open side of the upper part (30) is lockable by means of a cover (40) having on its upper side a marking means (45) and holes (46) for indicating elements such as luminescent diodes (47) or similar.

8. Housing according to claim 7, characterized by the fact, that the upper part (30) has latching elements (36) on its inner side which latch into attachments (43) of the pluggable edge (42) of the cover (40).

9. Housing according to one of the claims 1 to 8, characterized by the fact, that the bottom (21) of the lower part (20) is provided with a bore (14) intended for a fixing screw (16) going through the plug (15) and screwable into a thread (13) of the plug connector (11), and that the fixing screw (16) can be introduced through a sleeve (35) and shaped on the upper part (30) through a bore (44) of the cover (40), whereby the bore (44) of the cover (40), the through hole (39) of the sleeve (35) and the bore (14) of the bottom (21) of the lower part (20) are in line with the housing assembled.

10. Housing according to claim 3, characterized by the fact, that the location (34) for the plate (27) of the lower part (20) is shaped by an intermediate wall relative to the side wall (37) of a narrow side of the upper part (30) and that the bottom (31) of the upper part (30) is cut out between this intermediate wall (49) and this side wall.

11. Housing according to one of the claims 1 to 10, characterized by the fact, that after the connection of the lower (20) and upper (30) parts and the installation and connection of the electrical elements with the leads (23), the upper part (30) is sealed with sealing mass.

**Revendications**

1. Boîtier destiné à loger les composants électriques nécessaires à l'activation d'une bobine d'aimant d'une valve (10) hydraulique ou similaire, la bobine magnétique étant munie d'une connexion (11) à fiches comportant des contacts mâles (12) et le boîtier présentant une plaque de connexion comportant des parties femelles (22) destinées à recevoir ces contacts mâles (12), cette plaque de connexion étant munie de conducteurs électriques (23) qui relient les contacts (12) mâles aux composants électriques du boîtier et la plaque de connexion étant disposée entre la connexion (11) à fiches et la fiche (15) qui peut être enfichée sur cette dernière, boîtier caractérisé en ce, qu'il est constitué par une partie inférieure (20) en forme de cuvette et une partie supérieure (30) en forme de cuvette, en ce que la partie inférieure (20) et la partie supérieure peuvent être reliées entre elles, dans la zone de leur plan de jonction (30), au moyen d'éléments d'encliquetage (28, 29, 32, 33) adaptés les une aux autres, en ce que le fond (21) de la partie inférieure (20) constitue une plaque de connexion et présente les conducteurs électriques (23) qui passent dans une paroi latérale (26) de la partie inférieure (20) jusqu'à la partie supérieure (30), et en ce que le fond (21) et les parois latérales (24, 25, 26) de la partie inférieure (20) et le fond (31) de la partie supérieure (30) entourent, au moins partiellement, sur cinq côtés la fiche (15, 15') et aussi la maintiennent, ou la fixent dans le boîtier.

2. Boîtier selon la revendication 1, caractérisé en ce, que la partie inférieure (20) a une configuration comportant une section rectangulaire, en ce que le côté étroit de la partie inférieure (20) est ouvert et en ce que les conducteurs électriques (23) sont insérés dans la paroi latérale (26) du côté étroit opposé et dépassent au-dessus de la face supérieure ouverte de la partie inférieure (20).

3. Boîtier selon la revendication 2, caractérisé en ce, que les conducteurs électriques (23), qui dépassent au-dessus de la face supérieure ouverte de la partie inférieure (20), sont insérés dans une plaque (27) reliée à la partie inférieure (20), qui peut s'enfiler dans un logement (34) ménagé dans la partie supérieure (30), et en ce que les extrémités des conducteurs électriques (23) sortent sur le bord supérieur de la plaque (27) et passent dans l'espace intérieur de la partie supérieure (30).

4. Boîtier selon la revendication 1, caractérisé en ce, que les parois latérales (24, 25) sont munies, sur les côtés longitudinaux de la partie inférieure (20), d'évidements (18, 19) en forme de demi-cercle qui débouchent sur le côté étroit ouvert de la partie inférieure (20) et qui sont adaptés aux dimensions de la partie de la fiche (15, 15') qui dépasse du boîtier.

5. Boîtier selon une des revendications 1 à 4, caractérisé en ce, que les parois latérales (24, 25) correspondant aux côtés longitudinaux de la partie inférieure (20) portent à leur partie supérieure, ainsi que les parois latérales correspondant aux côtés longitudinaux de la partie supérieure (30), à leur partie inférieure, des dents (28, 32) plates d'encliquetage et des parties femelles (29, 33) adaptées à ces dernières, disposées et réparties de façon adaptée les unes aux autres.

6. Boîtier selon la revendication 5, caractérisé en ce, que dans la zone des dents (28, 32) d'encliquetage et des parties femelles (29, 33) d'encliquetage sont formées, du côté intérieur de la partie inférieure (20) et de la partie supérieure (30), des plaques (48) de guidage qui alignent les dents (28, 32) d'encliquetage et les parties femelles (29, 33) d'encliquetage de la partie inférieure (20) et de la partie supérieure (30) sur les deux plans de jonction dans la zone des parois latérales (24, 25) correspondant aux côtés longitudinaux.

7. Boîtier selon une des revendications 1 à 6, caractérisé en ce, que la face supérieure ouverte de la partie inférieure (30) peut être fermée par un couvercle (40), qui est muni à sa partie supérieure d'une barrette indicative (45) et présente des trous débouchants (46) destinés au passage d'éléments d'affichage, tels que des diodes lumineuses (47) ou similaires.

8. Boîtier selon la revendication 7, caractérisé en ce, que la partie supérieure (30) porte sur son côté intérieur des éléments (36) d'encliquetage, qui s'encliquétent dans des parties femelles (43) d'encliquetage d'un bord (42) d'emboîtement de couvercle (40).

9. Boîtier selon une des revendications 1 à 8, caractérisé en ce, que le fond (21) de la partie inférieure (20) présente un trou (14) destiné à une vis (16) de fixation, qui passe à travers la fiche (15) et peut être vissée dans un filetage femelle (13) de la connexion à fiches (11), et en ce que la vis (16) de fixation peut être introduite dans un trou (44) du couvercle (40) et dans une douille (35) formée sur la partie supérieure (30), le trou (44) du couvercle (40), le trou (39) de passage de la douille (35) et le trou (14) du fond (21) de la partie inférieure (20) étant alignés dans le boîtier assemblé.

10. Boîtier selon la revendication 3, caractérisé en ce, que le logement (34) de la plaque (27) dans la partie inférieure (20) est formé par une cloison intermédiaire placée en face de la paroi latérale (37) d'un côté étroit de la partie supérieure (30), et en ce que le fond (31) de la partie supérieure (30) est ajouré entre cette cloison intermédiaire (49) et cette paroi latérale.

11. Boîtier selon une des revendications 1 à 10, caractérisé en ce, qu'après l'assemblage de la partie inférieure (20) et de la partie supérieure (30) ainsi que la mise en place et la connexion des composants électriques avec les conducteurs électriques (23), la partie supérieure (30) est remplie d'une matière coulée.

0 082 469

Fig.4

Fig.3

Fig.2

Fig.1

9

Fig.6

Fig.5

Fig.7          Fig.8